# EUROPEAN PATENT APPLICATION

(11) **EP 1 635 199 A1**
(43) Date of publication of application: **15.03.2006**
(21) Application number: 04021773.9
(22) Date of filing: 14.09.2004
(51) Int. Cl.: G02B 5/30, G02B 27/28, G03F 7/00

(54) **Wire grid polarizer and manufacturing method thereof**

(71) Applicant: LG ELECTRONICS INC., Seoul (KR)
(72) Inventor: Ahn, Seh Won, Seoul (KR); Lee, Ki Dong, Seocho-gu Seoul 131-124 (KR); Lee, Sung Eun, Seoul (KR); Yoon Sang Soo, Anyang-si Kyunggi-do (KR); Kim, Jin Sung, Boondang-gu Seongnam-si Kyungg-do (KR); Park, Joo Do, Dongan-gu Anyang-si Kyunggi-do (KR)
(74) Representative: Heinze, Ekkehard

(57) **Abstract**

A manufacturing method of a wire grid polarizer includes the steps of: preparing a mold (330); sequentially forming a metal foil (310a) and a polymer (320b) on a substrate (300); molding a polymer by using the mold (330); etching the metal foil by using the molded polymer, and forming a wire grid pattern; and removing the polymer (320b).

## Description

### BACKGROUND OF THE INVENTION

### 1. Field of the Invention

The present invention relates in general to a wire grid polarizer and a manufact uring method thereof, more particularly, to a wire grid polarizer for visible light and a manuf acturing method thereof.

### 2. Discussion of the Background Art

The use of an array of parallel conducting wires to polarize specific light of rad io waves dates back more than 100 years.

The array of parallel conducting wires is generally called a wire grid. The wire grid, formed on a transparent substrate, is also used as a polarizer for the infrared portion o f the electromagnetic spectrum.

The key factor that determines the performance of a wire grid polarizer is the r elationship between the wire-to-wire spacing, namely period of the parallel grid elements and the wavelength of the incident light.

If the period of the wire grid is longer than the wavelength of the incident light , the wire grid functions as a diffraction grating, rather than as a polarizer, and diffracts the p polarized incident light.

Then, according to well-known principles, a diffraction and interference patter n is formed.

However, if the period or the grid spacing is shorter than the wavelength, the wire grid functions as a polarizer that reflects electromagnetic radiation polarized parallel to t he grid, and transmits radiation of the orthogonal polarization.

Quality criteria for the manufacture of a wire grid polarizer beam splitter are p eriod, line width, characteristics of grid material, substrate features (index of refraction), and wavelength and incidence angle of the incident light.

Here, many studies show that the characteristics of grid material have the least effect on the performance features of the polarization beam splitter.

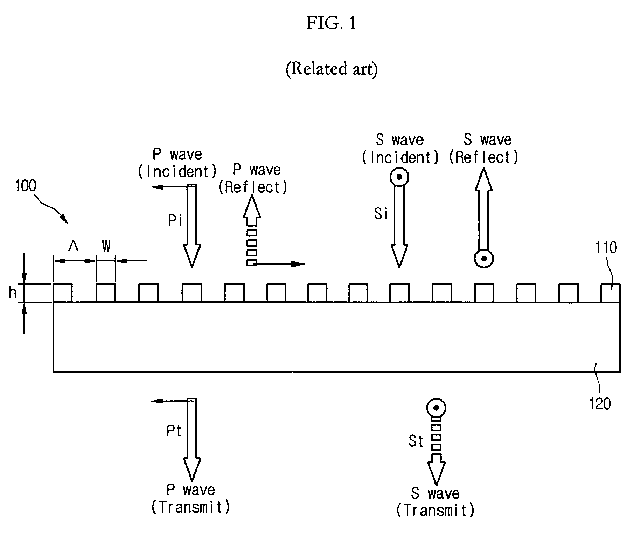

Fig. 1 illustrates a related art wire grid.

As shown in Fig. 1, the wire grid 100 is composed of a plurality of parallel con ductive wires 110 supported by an insulating substrate 120.

The period of the conductive wire 110 is denoted as 'A', the width of the cond uctive wire 110 is denoted as 'w', and the thickness of the conductive wire is denoted as 't'.

Based on the general definitions of the S-polarization and the P-polarization, t he S polarized light has a polarization vector orthogonal to the plane of incidence and thus, it is parallel to the conductive elements.

In contrast, the P polarized light has a polarization vector parallel to the incide nce plane and thus, it is orthogonal to the conductive elements.

If the period (or the center-to-center spacing) of the conductive wires 110 is sh orter than the wavelength of the electromagnetic radiation, the wire grid reflects the polarizat ion element (s-polarization) parallel to the conductive wires 110, and transmits the polarizatio n element (p-polarization) orthogonal to the conductive wires 110.

Usually, the wire grid polarizer reflects light with its electric field vector paralle 1 to the conductive wires, and transmits light with its electric field vector perpendicular to the conductive wires. Meanwhile, the plane of incidence may or may not be perpendicular to t he wires of the grid. The geometric notations used here are for information clarification.

An ideal wire grid will function as a perfect mirror for one polarization of light , the S polarized light, and will be perfectly transparent for the other polarization, the P polari zed light for example.

In practice, however, reflective metals used as mirrors absorb some fraction of the incident light and reflect only 90 - 95%, and plain glass does not transmit 100% of the i ncident light because of surface reflections.

Referring back to Fig. 1, the performance of the wire grid polarizer can be cha racterized by the polarization extinction ratio and the transmittance.

Here, the polarization extinction ratio and the transmittance are expressed by t he following equations.

Polarization extinction ratio : *(Si*/*St*)| _{Pi = 0}

Transmittance: (*Pt* / *Pi*) | _{Si = 0}

In the equations, the polarization extinction ratio indicates the ratio of the opti cal power of the incidented S wave (Si) to the transmitted S wave St) when the S polarized lig ht incidents; and the transmittance indicates the ratio of the optical power of the incidented P wave (Pt) to the incidented P wave (Pi) when the P polarized light incidents.

For the wire grid polarizer to have a high polarization extinction ratio, the peri od of the wire grid should be much shorter than the wavelength of the incident light.

So far, it has been very difficult to manufacture wire grid polarizers with a shor ter period of the wire grid, so wire grid polarizers were developed only for use in the infrared or microwave regions. Primarily, this is because the period of the wire grid needs to be sh ortened as the wavelength of the polarized light has the short wavelength.

However, with recent advances in semiconductor fabrication equipment and e xposure technologies, including the fine pattern generation technology, it is now possible to produce wire grid polarizers for visible light.

The visible light resides in the electromagnetic spectrum which is visible to hu man eyes. The visible spectrum consists of wavelengths between 400nm to 700nm.

That is, for the wire grid polarizer to have the high ERs (Extinction Ranges) fo r three primary colors (R, G, and B), the period of the wire grid should be at least 200nm to obtain somewhat desired polarization characteristics. To improve the polarization perform ance of existing polarizers, a wire grid with its period shorter than 0.1 µm is required.

The line width of a recently developed semiconductor processing is approxima tely 0.1 µm. When drawing lines periodically, the spacing between the lines should be the s ame with the line width, which means that the period of the wire grid is 0.2 µm.

Here, if the interference effect can be generated by using an argon laser having a short wavelength, it is possible to make the period of the wire grid as short as 200nm.

Also, if the period of the related art wire grid polarizer is reduced from 200nm to 100nm, the performance of the wire grid polarizer will be noticeably improved. Therefor e, there is a need to develop a wire grid polarizer with a short period.

### SUMMARY OF THE INVENTION

An object of the invention is to solve at least the above problems and/or disad vantages and to provide at least the advantages described hereinafter.

Accordingly, one object of the present invention is to solve the foregoing prob lems by providing a wire grid polarizer for visible light and a manufacturing method thereof using embossing technique, whereby wire grid polarizers can be more easily and repeatedly m anufactured.

Another object of the present invention is to provide a wire grid polarizer havi ng excellent polarizing performance at the R, G, and B wavelengths in the visible spectrum.

The foregoing and other objects and advantages are realized by providing a ma nufacturing method of a wire grid polarizer, the method including the steps of: preparing a m old; sequentially forming a metal foil and a polymer on a substrate; molding a polymer by usi ng the mold; etching the metal foil by using the molded polymer, and forming a wire grid pat tern; and removing the polymer.

According to another aspect of the invention, a manufacturing method of a wi re grid polarizer includes the steps of: preparing a mold; coating a substrate with a polymer; f orming a polymer pattern by using the mold; etching the polymer pattern and exposing part of the substrate; depositing a metal foil onto the polymer pattern and the exposed substrate; and removing the polymer pattern.

Additional advantages, objects, and features of the invention will be set forth i n part in the description which follows and in part will become apparent to those having ordi nary skill in the art upon examination of the following or may be learned from practice of the invention. The objects and advantages of the invention may be realized and attained as pa rticularly pointed out in the appended claims.

### BRIEF DESCRIPTION OF THE DRAWINGS

The invention will be described in detail with reference to the following drawi ngs in which like reference numerals refer to like elements wherein:

Fig. 1 illustrates a related art wire grid;

Fig. 2 is a graph showing the relationship between the period of a wire grid an d the polarization extinction ratio in the visible light band;

Figs. 3A through 3E diagrammatically illustrate a process for producing a mold for manufacturing a wire grid according to the present invention;

Figs. 4A to 4H illustrate a sequence of a manufacturing process of a wire grid polarizer, according to a first embodiment of the present invention; and

Figs. 5A to 5G illustrate a sequence of a manufacturing process of a wire grid polarizer, according to a second embodiment of the present invention.

### DETAILED DESCRIPTION OF PREFERRED EMBODIMENTS

The following detailed description will present a wire grid polarizer according t o a preferred embodiment of the invention in reference to the accompanying drawings.

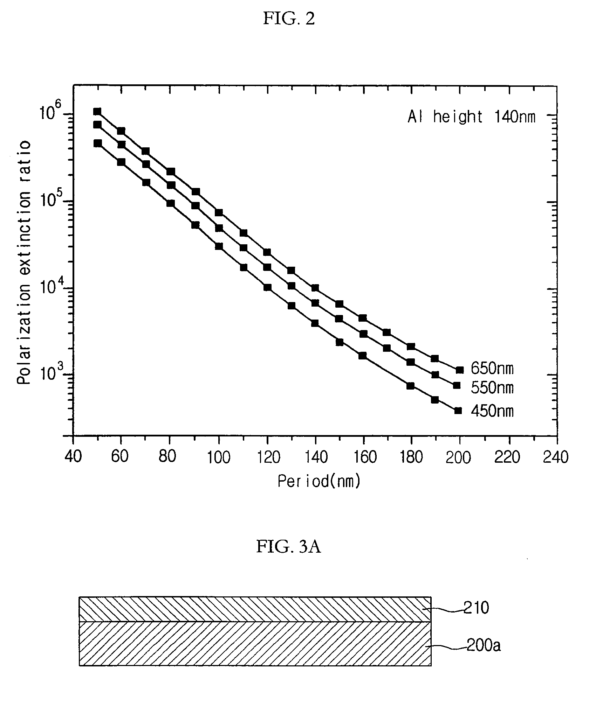

Fig. 2 is a graph showing the relationship between the period of a wire grid an d the polarization extinction ratio in the visible light band.

As shown in Fig. 2, the polarization efficiency of the wire grid polarizer is in a close relationship with the period of the wire grid.

The material of the wire grid is aluminum (Al), and the height of the wire grid i s 140nm.

And, the line width of the wires of the grid is 60nm, the periods of the R, the G, and the B light are 450nm, 550nm, and 650nm, respectively.

To obtain the polarization extinction ratio higher than 10,000 : 1, the grid peri od should be shorter than 120nm.

Before manufacturing the wire grid polarizer using the embossing technique, a mold should be prepared first.

Figs. 3A through 3E diagrammatically illustrate a process for producing a mold for manufacturing the wire grid according to the present invention.

Preferably, the mold is made from silicon, SiO₂, quartz glass, Ni, Pt, Cr, and p olymers.

The embossing technique for use in the manufacture of the wire grid is largely divided into two types: hot embossing technique that applies heat for molding polymer; and UV embossing technique that presses the mold, and solidifies the polymer by using ultra viol et light.

All of the above described materials can be used with the hot embossing techn ique. Particularly, quartz glass and transparent polymers which are transparent materials ca n also be used with the UV embossing technique.

Referring to Fig. 3A, a polymer layer 210 is sprayed or spin coated on a mold s ubstrate 200, such as silicon.

Preferably, the polymer layer 210 is made from an electron beam sensitive mat erial, PMMA (polymethylmethacrylate) for example.

Multiplexing usually occurs in the electron beam sensitive part of the polymer, and using this nature, it is possible to obtain a desired pattern through electron beam irradiati on and developing processes.

If the polymer is a positive photosensitizer, an electron beam irradiated part m elts in the developer, while if the polymer is a negative photosensitizer, the rest of the polyme r except for the electron beam irradiated part melt in the developer.

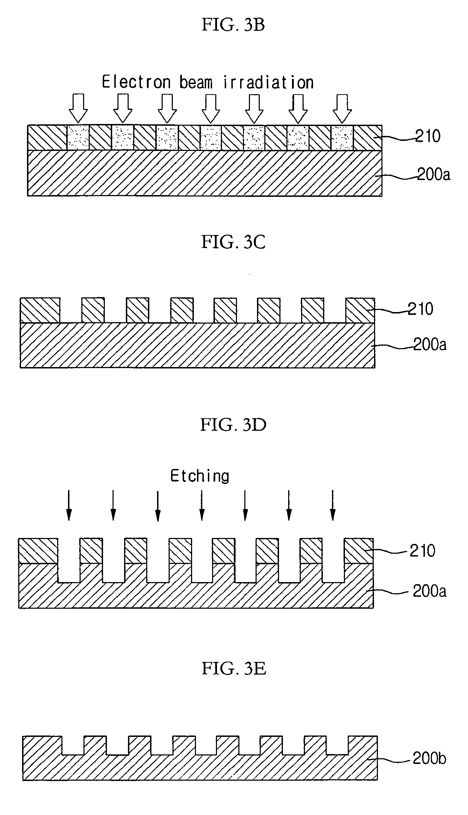

As shown in Fig. 3B, after the polymer layer 210 is formed on the mold substr ate 200a, a grid pattern is formed on the polymer layer 210 through the electron beam irradia tion.

Next, as shown in Fig. 3C, the mold substrate 200a and the polymer layer 210 are dipped in the developer to ensure the grid pattern is developed as it is.

As shown in Fig 3D, the grid pattern is used as an etching mask, and the mold substrate is dry etched or wet etched.

Lastly, the polymer layer used as the etching mask is removed, and as shown in Fig. 3E, the mold 200b with a desired pattern for manufacturing the wire grid is produced.

Here, the surface of the mold is treated with a silane-containing chemical to fa cilitate the separation of the polymer and the mold.

Thusly prepared mold is then used for manufacturing the wire grid polarizer o perating in the visible band.

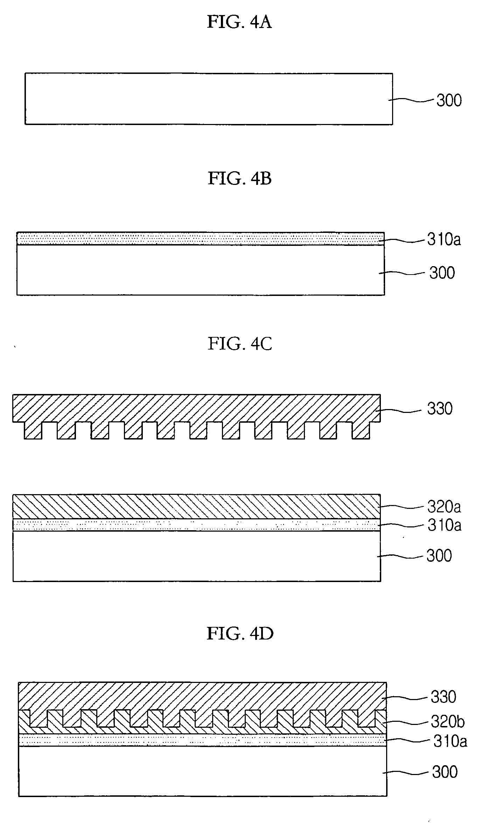

Figs. 4A to 4H illustrate a sequence of a manufacturing process of a wire grid polarizer, according to a first embodiment of the present invention.

As described before, the wire grid polarizer is manufactured by using the pre-made mold. To this end, a transparent glass substrate 300 with both surfaces polished is fir st prepared (refer to Fig. 4A).

Then, as shown in Fig. 4B, a thin metal foil 310a is deposited on the glass subs trate 300.

The metal foil 310a can be made from Al, Ag, or Cr.

Later, the metal foil 310a is coated with a polymer 320a, as shown in Fig. 4C.

The polymer 320a is pressed by the mold 330, and as a result, the pattern from the mold is printed onto the polymer 320a.

Here, if the polymer 320a is a thermosetting material, a metal mold is employe d, and if the polymer 320a is a UV cure material, a transparent polymer mold is employed.

In the former case where the polymer 320a is a thermosetting material, the hot embossing technique is used to pre-bake the polymer. In the later case where the polymer 320a is a UV cure material, the UV embossing technique is used, so that the coated polymer is not cured and a transparent mold is used.

As shown in Fig. 4D, by applying heat or irradiating ultraviolet light onto the mold 330, the polymer 320b is cured or solidified.

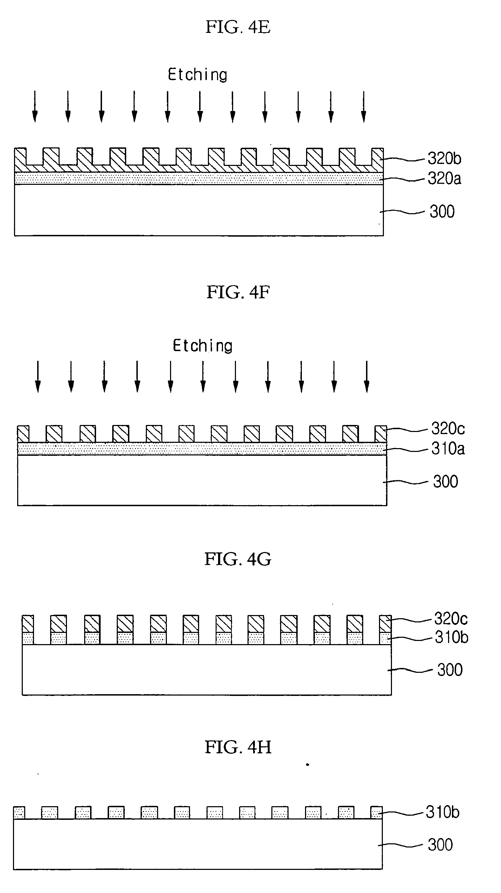

Afterwards, as shown in Fig. 4E, the mold 330 is separated from the polymer 320b.

Then, the pattern from the mold 330 is printed onto the polymer 320b, that is, the polymer has an opposite pattern to the pattern from the mold 330.

In case of using the hot embossing technique, the mold 330 has to be separate d from the polymer 320b after the temperature of the substrate is sufficiently cooled down.

In case of using the UV embossing technique, the mold 330 is separated from the polymer 320b after the UR curing is finished.

Next, the front surface of the polymer 320b is dry etched to exposure the surfa ce of the metal foil 310a, as shown in Fig. 4F.

Since part of the polymer 320c is recessed by the pattern from the mold 330, a relatively thin part of the polymer 320c is removed by the etching process, thereby exposing the metal foil 310a to the surface.

Afterwards, the exposed metal foil 310a is dry etched or wet etched, and as a r esult, a wire grid pattern 310b is formed as shown in Fig. 4G.

Finally, as shown in Fig. 4H, the polymer 320c remaining on the wire grid patt em 310b is removed.

In this procedure, the wire grid polarizer with a desired grin pattern on the sub strate 300 is manufactured.

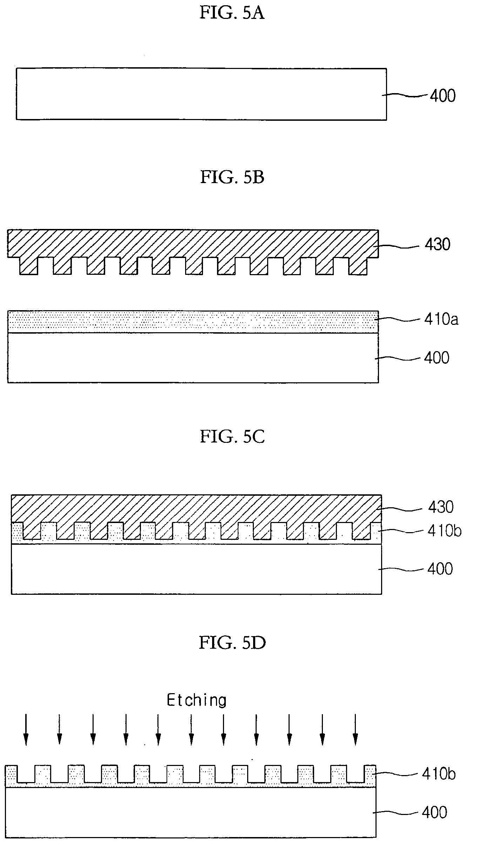

Figs. 5A to 5G illustrate a sequence of a manufacturing process of a wire grid polarizer, according to a second embodiment of the present invention.

As explained before, the wire grid polarizer is manufactured by using the pre-made mold. To this end, a transparent glass substrate with both surfaces polished is first pr epared (refer to Fig. 5A).

Later, as shown in Fig. 5B, the glass substrate 400 is coated with a polymer 410 a, and the mold 430 is prepared.

Then, the polymer 410a is pressed by the mold 430, and as a result, the pattern from the mold 430 is printed onto the polymer 410b, as shown in Fig. 5C.

The pattern printed onto the polymer 410b is opposite to the pattern from the mold 430.

As shown in Fig. 5D, by applying heat or irradiating ultraviolet light onto the mold 430, the polymer 410b is cured or solidified

In case of using the hot embossing technique, the mold 430 has to be separate d from the polymer 410b after the temperature of the substrate 400 is sufficiently cooled do wn.

In case of using the UV embossing technique, the mold 430 is separated from the polymer 410b after the UR curing is finished.

Here, if the polymer is a thermosetting material, a metal mold is employed, and if the polymer is a UV cure material, a transparent polymer mold is employed.

In the former case where the polymer is a thermosetting material, the hot emb ossing technique is used to pre-bake the polymer. In the later case where the polymer is a UV cure material, the UV embossing technique is used, so that the coated polymer is not cur ed and a transparent mold is used.

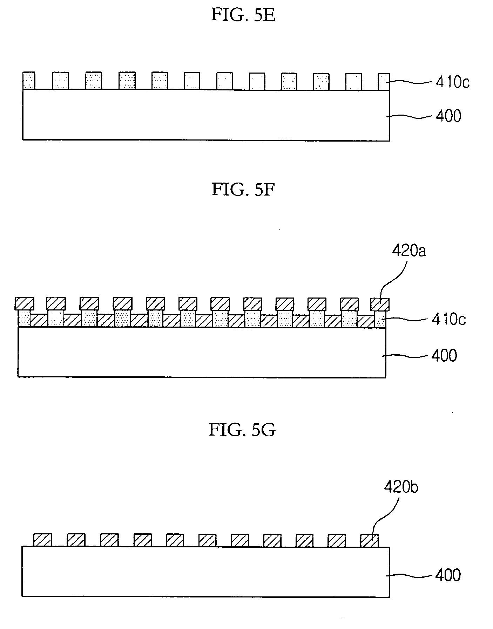

Afterwards, the front surface of the polymer 41cb is dry etched to exposure th e surface of the substrate 400, as shown in Fig. 5E.

Since part of the polymer 410c is recessed by the pattern from the mold 430, a relatively thin part of the polymer 410c is removed by the etching process, thereby exposing the substrate 400 to the surface.

Next, a metal foil 420a is vacuum deposited on the glass substrate 400, as sho wn in Fig. 5F.

The metal foil 420a can be made from Al, Ag, or Cr.

Later, the polymer 410c with the deposited metal foil 420a is dipped into an et chant and is removed. At the end, a wire grid pattern 420b shown in Fig. 5G is obtained.

In this procedure, the wire grid polarizer with a desired grin pattern on the sub strate 400 is manufactured.

In conclusion, the wire grid polarizer of the present invention is advantageous for reducing the manufacture cost in that it can be mass produced by using a mold over and over.

Also, the manufacturing method of the wire grid polarizer of the present inven tion does not require additional equipment, and its process takes a short time, consequently i ncreasing yield.

Moreover, the wire grid polarizer has the high polarization extinction ratio at v isible wavelengths, so that it can be broadly used in diverse applications such as flat displays, projection displays, optical equipment, and so on.

While the invention has been shown and described with reference to certain pr eferred embodiments thereof, it will be understood by those skilled in the art that various cha nges in form and details may be made therein without departing from the spirit and scope of the invention as defined by the appended claims.

The foregoing embodiments and advantages are merely exemplary and are not to be construed as limiting the present invention. The present teaching can be readily appli ed to other types of apparatuses. The description of the present invention is intended to be illustrative, and not to limit the scope of the claims. Many alternatives, modifications, and variations will be apparent to those skilled in the art. In the claims, means-plus-function claus es are intended to cover the structures described herein as performing the recited function an d not only structural equivalents but also equivalent structures.

The claims refer to examples of preferred embodiments of the invention. How ever, the invention also refers to the use of any single feature and subcombination of features which are disclosed in the claims, the description and/or in the drawings.

## Claims

1. A wire grid polarizer comprising:
a substrate; and
a wire grid pattern formed on the substrate by a mold, and having a shorter than 120n m of period for the wire grid.

2. The wire grid polarizer according to claim 1, wherein a material for the mold is selecte d from a group consisting of silicon, SiO₂, quartz glass, Ni, Pt, Cr, and polymers.

3. The wire grid polarizer according to claim 1, wherein the wire grid pattern is printed f rom the mold by using a hot embossing or a UV embossing technique.

4. A manufacturing method of a wire grid polarizer, the method comprising the steps of:
preparing a mold;
sequentially forming a metal foil and a polymer on a substrate;
molding a polymer by using the mold;
etching the metal foil by using the molded polymer, and forming a wire grid pattern; a nd
removing the polymer.

5. The method according to claim 4, wherein a material for the mold is selected from a g roup consisting of silicon, SiO₂, quartz glass, Ni, Pt, Cr, and polymers.

6. The method according to claim 4, wherein the polymer molding step by using the mol d comprises the sub-steps of:
pressing the mold to the polymer to print the pattern from the mold onto the polymer ;
curing the polymer; and
separating the mold from the polymer.

7. The method according to claim 4, wherein the polymer is a thermosetting material or a UV cure material.

8. The method according to claim 4, wherein the step for preparing the mold comprises the sub-steps of:
forming a photosensitive polymer on the mold substrate;
patterning the photosensitive polymer;
etching the mold substrate by using the photosensitive polymer as a mask; and
removing the photosensitive polymer.

9. The method according to claim 8, wherein the photosensitive polymer is patterned by using photolithography, electron beam lithography, and semiconductor exposure processes.

10. The method according to claim 4, wherein the metal foil is dry etched or wet etched.

11. The method according to claim 8, wherein to remove the photosensitive polymer mor e easily, the surface of the mold is treated with a silane containing chemical.

12. A manufacturing method of a wire grid polarizer, the method comprising the steps of:
preparing a mold;
coating a substrate with a polymer;
forming a polymer pattern by using the mold;
etching the polymer pattern and exposing part of the substrate;
depositing a metal foil onto the polymer pattern and the exposed substrate; and
removing the polymer pattern.

13. The method according to claim 12, wherein a material for the mold is selected from a group consisting of silicon, SiO₂, quartz glass, Ni, Pt, Cr, and polymers.

14. The method according to claim 12, wherein the step for forming the polymer pattern by using the mold comprises the sub-steps of:
pressing the mold to the polymer to print the pattern from the mold onto the polymer ;
curing the polymer; and
separating the mold from the polymer.

15. The method according to claim 12, wherein the polymer is a thermosetting material or a UV cure material.

16. The method according to claim 12, wherein the step for preparing the mold comprise s the sub-steps of:
forming a photosensitive polymer on the mold substrate;
patterning the photosensitive polymer;
etching the mold substrate by using the photosensitive polymer as a mask; and
removing the photosensitive polymer.

17. The method according to claim 16, wherein the photosensitive polymer is patterned b y using photolithography, electron beam lithography, and semiconductor exposure processes.

18. The method according to claim 12, wherein the metal foil is dry etched or wet etched.

19. The method according to claim 16, wherein to remove the photosensitive polymer m ore easily, the surface of the mold is treated with a silane containing chemical.
